Europäisches Patentamt

European Patent Office

Office européen des brevets

(19)

(11) Veröffentlichungsnummer: **0 199 233**
**B1**

(12) # EUROPÄISCHE PATENTSCHRIFT

(45) Veröffentlichungstag der Patentschrift:
31.01.90

(51) Int. Cl.⁴: **E06B 3/66,** H01L 25/04

(21) Anmeldenummer: **86105068.0**

(22) Anmeldetag: **14.04.86**

(54) **Bauelement für den Hochbau und seine Verwendung.**

(30) Priorität: **17.04.85 DE 3513873**

(43) Veröffentlichungstag der Anmeldung:
**29.10.86 Patentblatt 86/44**

(45) Bekanntmachung des Hinweises auf die Patenterteilung:
**31.01.90 Patentblatt 90/5**

(84) Benannte Vertragsstaaten:
**AT BE CH DE FR GB IT LI NL SE**

(56) Entgegenhaltungen:
EP-A- 0 028 820
BE-A- 895 737
DE-A- 2 942 328
DE-A- 3 125 622
FR-A- 1 340 426
FR-A- 2 407 182
GB-A- 2 077 995
US-A- 4 186 033

(73) Patentinhaber: **Siemens Aktiengesellschaft,
Wittelsbacherplatz 2, D-8000 München 2(DE)**

(72) Erfinder: **Bednorz, Klaus, Leopoldstrasse 138,
D-8000 München 40(DE)**
Erfinder: **Zehetbauer, Rudolf, Gelbhofstrasse 10,
D-8000 München 70(DE)**
Erfinder: **Riermeier, Manfred, Finkenweg 1,
D-8059 Oberneuching(DE)**

**Beschreibung**

Die Erfindung betrifft ein Bauelement für den Hochbau nach dem Oberbegriff des Anspruchs 1. Ein solches Bauelement ist aus FR-A 2 402 182 bekannt.

Im Hochbau werden Bauelemente benötigt, die eine hohe Wärmedämmung aufweisen. Als Fensterbauelemente haben sich dabei besonders Fenster mit Isolierverglasung bewährt. Fenster mit Isolierverglasung werden im wesentlichen nach drei verschiedenen Verfahren hergestellt. Bei einem dieser Verfahren werden zwei oder mehrere Glasscheibe jeweils an ihrer äußeren Umrandung metallisiert. Diese metallisierten Glasscheiben werden sodann mit einem äußeren Rahmen versehen. Dabei wird die Metallisierung der Glasscheiben mit dem äußeren Rahmen fest verbunden, beispielsweise verlötet oder verschmolzen. Bei einem zweiten Verfahren werden zwei oder mehrere Glasscheiben an ihrer äußeren Umrandung dadurch miteinander verbunden, daß das an der äußeren Umrandung der Glasscheiben befindliche Glas geschmolzen und dann mittelbar oder unmittelbar diese Glasumrandungen miteinander verbunden werden. Bei einem dritten Verfahren werden mindestens zwei Glasscheiben zusammen mit einem Rahmen verklebt. Dieses Verkleben kann beispielsweise dadurch erfolgen, daß zwischen jeweils zwei Glasscheiben ein metallischer Rahmen eingelegt wird und daß dieser Verbund aus zwei Glasscheiben und einem dazwischenliegenden äußeren metallischen Rahmen mit einem Klebstoff versiegelt wird. Dieses letztgenannte Verfahren läßt sich mit einem geringen Aufwand an Arbeitsschritten, Material und Kosten durchführen.

Der vorliegenden Erfindung liegt die Aufgabe zugrunde, ein Bauelement der eingangs genannten Art anzugeben, das wärmedämmend wirkt und zugleich mit einem besonders hohen Wirkungsgrad Energie liefern kann.

Diese Aufgabe wird erfindungsgemäß durch ein Bauelement nach dem Anspruch 1 gelöst.

Bei einem Bauelement nach der Erfindung können eine oder mehrere Solarzellen auf vielfältige Art und Weise im Inneren der Isolierverglasung angeordnet sein. Die Isolierverglasung kann mit Glasscheiben oder mit glasähnlichen Kunststoffscheiben aufgebaut sein. Bei Verwendung eines Bauelements nach der Erfindung als Fassadenelement muß nur eine einzige Glasscheibe oder glasähnliche Kunststoffscheibe lichtdurchlässig sein.

Wenigstens eine Solarzelle kann im Inneren einer glasähnlichen Kunststoffscheibe und damit im Inneren der Isolierverglasung angeordnet sein. Auf diese Weise lassen sich Bauelemente herstellen, die in den Bereichen außerhalb der Solarzellen durchsichtig sind.

Solarzellen können auf einer Innenseite einer Glasscheibe oder einer glasähnlichen Kunststoffscheibe im Inneren der Isolierverglasung festgeklebt sein. Wenn dieses Festkleben mit einem transparenten Kleber erfolgt, ist das Bauelement in den Zwischenbereichen zwischen verschiedenen Solarzellen immer noch durchsichtig. Wenn das Festkleben der Solarzellen auf der Innenseite einer Glasscheibe oder einer glasähnlichen Kunststoffscheibe mit einem schmelzbaren Kleber erfolgt, wird das gesamte Bauelement im allgemeinen nur noch lichtdurchlässig ähnlich wie ein Glasbaustein sein, wird jedoch nicht mehr durchsichtig sein. Ein solches Bauelement kann zur Erhellung von Innenräumen dienen.

Solarzellen können auch auf eine Oberfläche im Inneren der Isolierverglasung des Bauelements aufgedampft oder sonstwie aufgebracht sein.

Ein Bauelement nach der Erfindung kann als Fassadenelement verwendet werden. Dabei dient das Fassadenelement nicht nur zur Wärmedämmung, sondern kann bei entsprechender Ausgestaltung auch zur Erhöhung von ästhetischen Wirkungen dienen und somit bei der Architektur als gestalterisches Element eingesetzt werden.

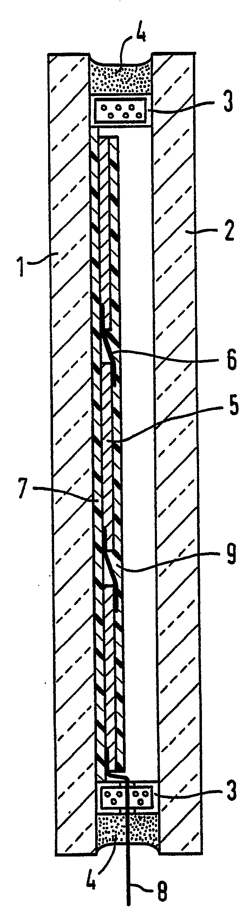

Die Erfindung wird anhand der Zeichnung näher erläutert.

Die Figur zeigt ein Bauelement nach der Erfindung im Schnitt:

Auf die Innenseite der Glasscheibe 1 wird eine schmelzbare Folie 7 aufgebracht. Diese schmelzbare Folie 7 kann beispielsweise aus Polyvinylbutyral oder aus Äthylenvinylacetat bestehen. Die Verwendung solcher Thermoplast-Folien bei Solarmodulen, die in einer Verbundglas analogen Form hergestellt werden, ist beispielsweise aus den US-Patentschriften 4 067 764 und 4 224 081 bekannt. Die Herstellung von Solarmodulen mit einem Rahmen ist beispielsweise aus den US-Patentschriften 4 231 807, 4 371 739, 4 401 839 und 4 433 200 bekannt. Wenn auf die Glasscheibe 1 die schmelzbare Folie 7 und auf diese schmelzbare Folie die Solarzellen 5 zusammen mit ihrer elektrischen Verschaltung 6 aufgebracht sind, kann dieser Verbund unter Einwirkung von Wärme und/oder Druck in an sich bekannter Weise zu einem mechanisch stabilen Verbund zusammengefügt werden.

Die Solarzellen können auch durch eine zusätzliche Folie 9 aus PVB (Polyvinylbutyral) oder EVA (Äthylenvinylacetat) eingebettet sein.

Auf diesen Verbund aus Glasscheibe 1, schmelzbarer Folie 7 und Solarzellen 5 nebst elektrischer Beschaltung 6 wird ein Rahmen 3 aufgelegt. Auf diesen Rahmen 3 wird wiederum eine weitere Glasscheibe 2 aufgebracht. Die elektrischen Anschlüsse 8 der Solarzellen 5 werden durch den Rahmen 3 hindurch nach außen geführt. In einer für die Herstellung von Fenstern mit Isolierverglasung bekannten Weise wird anschließend das Innere zwischen den beiden Glasscheiben 1, 2 mit Luft mit geringem Feuchtigkeitsgehalt gefüllt. Der Feuchtigkeitsgehalt der eingeschlossenen Luft wird zweckmäßigerweise durch absorbierende Mittel herabgesetzt, so daß Kondenswasserbildung auch bei tiefen Außentemperaturen vermieden wird. Als absorbierendes Mittel eignet sich neben anderen Mitteln ein Molekularsieb. Danach wird das Bauelement mit Hilfe von Thiokol 4 in einer dem Fachmann für ein Bauelement mit Isolierverglasung bekannten Weise versiegelt. Bei dieser Versiegelung des Bauelements werden auch die Durchführungen der elektrischen Anschlüsse 8 durch die Thiokolversiegelung hindurch vakuumdicht umschlossen.

Ein Bauelement mit einer Isolierverglasung nach der Erfindung mit mindestens einer integrierten Solarzelle hat gegenüber einem Solarmodul, bei dem Solarzellen zwischen zwei Glasscheiben eingebettet sind, bei dem jedoch keine Isolierverglasung vorhanden ist, den Vorteil, daß ein solches Bauelement auch im Winter nur geringe Wärmeverluste zuläßt. Bei einem Bauelement nach der Erfindung sind außerdem die Solarzellen 5 und ihre elektrische Verschaltung 6 im Inneren des Bauelements mechanisch geschützt.

Die Glasscheiben 1, 2 können aus 4 mm dickem Glas bestehen. Ein besonders hoher Wirkungsgrad wird dann erzielt, wenn für die äußere Scheibe 1, auf die beispielsweise das Sonnenlicht von außen einfällt, ein sogenanntes Solarglas, beispielsweise Planidur® der Firma Vegla, München, DE, verwendet wird. Solarglas ist beispielsweise eisenarm und läßt daher den Rotanteil des von außen einfallenden Lichtes mit einer höheren Energietransmission als normales weißes Fensterglas durch. Die Energietransmission kann dabei größer als 90% sein. Im Gegensatz dazu wird bei der normalen Bautechnik angestrebt, daß der Rotanteil des auf das Hochbau-Bauelement einfallenden Lichtes möglichst nicht durchgelassen wird. Die Kombination von Solarglas mit einer Isolierverglasung ermöglicht einen überraschend hohen Wirkungsgrad bei gleichzeitig nur geringen Wärmeverlusten auch im Winter.

Die Solarzellen 5 sind bevorzugt auf der Innenseite der äußeren Glasscheibe 1 befestigt. Es liegt im Rahmen der Erfindung, daß die Solarzellen an der Innenseite der hinteren Scheibe 2 befestigt sind. Dies ist im allgemeinen jedoch mit einem etwas geringeren Wirkungsgrad gegenüber der bevorzugten Ausführungsform verbunden.

## Patentansprüche

1. Bauelement für den Hochbau, bei dem im Inneren zwischen zwei Glasscheiben (1, 2) oder zwischen zwei glasähnlichen Scheiben oder zwischen einer Glasscheibe und einer glasähnlichen Scheibe wenigstens eine Solarzelle (5) angeordnet ist und das Bauelement eine versiegelte Isolierverglasung aufweist, dadurch gekennzeichnet, daß wenigstens eine Glasscheibe (1) aus Solarglas ist, das den Rotanteil des von außen einfallenden Lichtes mit einer höheren Energietransmission als normales weißes Fensterglas durchläßt.

2. Bauelement nach Anspruch 1, dadurch gekennzeichnet, daß wenigstens zwei Glasscheiben (1, 2) zusammen mit einem Rahmen (3) verklebt sind.

3. Bauelement nach Anspruch 1, dadurch gekennzeichnet, daß wenigstens zwei Glasscheiben an ihrer Berandung metallisiert und über diese Metallisierung mit einem Rahmen verbunden sind.

4. Bauelement nach Anspruch 1, dadurch gekennzeichnet, daß wenigstens zwei Glasscheiben miteinander verschmolzen sind.

5. Bauelement nach einem der Ansprüche 1 bis 4, dadurch gekennzeichnet, daß wenigstens eine Solarzelle (5) an der Innenseite der äußeren Glasscheibe (1) befestigt ist.

6. Bauelement nach einem der Ansprüche 1 bis 5, dadurch gekennzeichnet, daß wenigstens eine Solarzelle (5) an einer Glasscheibe (1) festgeklebt ist.

7. Bauelement nach einem der Ansprüche 1 bis 6, dadurch gekennzeichnet, daß wenigstens eine Glasscheibe (1) mit einem Kunststoff (7) bedeckt ist und daß auf diesem Kunststoff (7) wenigstens eine Solarzelle (5) angeordnet ist.

8. Bauelement nach Anspruch 7, dadurch gekennzeichnet, daß der Kunststoff (7) ein Thermoplast ist.

9. Verwendung eines Bauelements nach einem der Ansprüche 1 bis 8 als Fassadenelement.

10. Verwendung eines Bauelements nach einem der Ansprüche 1 bis 9 als Glasbaustein.

## Claims

1. Building construction element in which at least one solar cell (5) is arranged in the interior between two glass panes (1, 2) or between two glass-like panes or between a glass pane and a glass-like pane, and the construction element has sealed insulating glazing, characterized in that at least one glass pane (1) is made of solar glass which, with a higher energy transmission than normal white window glass, lets through the red proportion of the light incident from outside.

2. Construction element according to Claim 1, characterized in that at least two glass panes (1, 2) are adhesively bonded together with a frame (3).

3. Construction element according to Claim 1, characterized in that at least two glass panes are metallized at their boundary and are connected to a frame via this metallized section.

4. Construction element according to Claim 1, characterized in that at least two glass panes are fused to one another.

5. Construction element according to any of Claims 1 to 4, characterized in that at least one solar cell (5) is fixed to the inside of the outer glass pane (1).

6. Construction element according to any of Claims 1 to 5, characterized in that at least one solar cell (5) is adhesively bonded in place on a glass pane (1).

7. Construction element according to any of Claims 1 to 6, characterized in that at least one glass pane (1) is covered with a plastic (7), and in that at least one solar cell (5) is arranged on this plastic (7).

8. Construction element according to Claim 7, characterized in that the plastic (7) is a thermoplastic.

9. Use of a construction element according to any of Claims 1 to 8, as a facade element.

10. Use of a construction element according to any of Claims 1 to 9 as a glass block.

## Revendications

1. Elément de construction pour le bâtiment, dans lequel dans l'espace compris entre deux vitres en verre (1, 2) ou entre deux vitres en un matériau analogue à du verre ou entre une vitre en verre et une vitre en un matériau analogue à du verre, est montée au moins une cellule solaire (5), l'élément de construction comportant un vitrage isolant scellé, caractérisé en ce que l'une au moins des vitres en verre (1) est en verre solaire, qui laisse passer la partie rouge de la lumière incidente de l'extérieur avec une transmission d'énergie plus grande que du verre à vitre blanc normal.

2. Elément de construction suivant la revendication 1, caractérisé en ce qu'au moins deux vitres en verre (1, 2) sont collées ensemble à un cadre (3).

3. Elément de construction suivant la revendication 1, caractérisé en ce qu'au moins deux vitres en verre sont métallisées sur leurs bords et sont reliées à un cadre par cette métallisation.

4. Elément de construction suivant la revendication 1, caractérisé en ce qu'au moins deux vitres en verre sont reliées l'une à l'autre par fusion.

5. Elément de construction suivant l'une des revendications 1 à 4, caractérisé en ce qu'au moins une cellule solaire (5) est fixée au côté intérieur de la vitre en verre extérieure (1).

6. Elément de construction suivant l'une des revendications 1 à 5, caractérisé en ce qu'au moins une cellule solaire (5) est collée à une vitre en verre (1).

7. Elément de construction suivant l'une des revendications 1 à 6, caractérisé en ce qu'au moins une vitre en verre (1) est recouverte d'une matière plastique (7) et en ce que, sur cette matière plastique (7) est montée au moins une cellule solaire (5).

8. Elément de construction suivant la revendication 7, caractérisé en ce que la matière plastique (7) est une matière thermoplastique.

9. Application d'un élément de construction suivant l'une des revendications 1 à 8 comme élément de façade.

10. Application d'un élément de construction suivant l'une des revendications 1 à 9 comme pierre en verre.